# EUROPÄISCHE PATENTANMELDUNG

(11) **EP 2 631 937 A1**
(43) Veröffentlichungstag der Anmeldung: **28.08.2013**
(21) Anmeldenummer: 12156856.2
(22) Anmeldetag: 24.02.2012
(51) Int. Cl.: H01L 21/677, H01L 21/67, H01L 21/68

(54) **Stationsanordnung zur Bearbeitung und/oder Vermessen von Halbleiterscheiben sowie Bearbeitungsverfahren**

(71) Anmelder: Fraunhofer Gesellschaft zur Förderung der angewandten Forschung E.V., 80686 München (DE)
(72) Erfinder: Schellenberger, Martin, 91054 Erlangen (DE); Lewke, Dirk, 91056 Erlangen (DE)
(74) Vertreter: Pfenning, Meinig & Partner GbR

(57) **Zusammenfassung**

Die vorliegende Erfindung betrifft eine Stationsanordnung zur Bearbeitung und/oder Vermessung von Halbleiterscheiben bzw. -wafern, die mindestens ein Belademodul, mindestens eine Prozessstation zum Bearbeiten der Halbleiterscheiben und/oder mindestens eine Vermessstation zum Vermessen einer Größe der Halbleiterscheiben, mindestens eine Justage-/Kühl-Station sowie mindestens einen Transportroboter, der in einem Transportgehäuse angeordnet ist, als Einzel-Module umfasst. Der Transportroboter ermöglicht den Transport der zu bearbeitenden Halbleiterscheiben zwischen dem Belademodul und der jeweiligen Prozessstation zur Bearbeitung der Halbleiterscheiben und/oder der mindestens einen Vermessstation zum Vermessen der Halbleiterscheiben. Die Erfindung betrifft die besondere Anordnung der Justage/Kühl-Station innerhalb der Stationsanordnung, so dass ein möglichst geringer Platzbedarf der einzelnen Module innerhalb der Stationsanordnung und somit eine platzsparende Bauweise der Stationsanordnung insgesamt resultiert.

## Beschreibung

Die vorliegende Erfindung betrifft eine Stationsanordnung zur Bearbeitung und/oder Vermessung von Halbleiterscheiben bzw. -wafern, die mindestens ein Belademodul, mindestens eine Prozessstation zum Bearbeiten der Halbleiterscheiben und/oder mindestens eine Vermessstation zum Vermessen einer Größe der Halbleiterscheiben, mindestens eine Justage-/Kühl-Station sowie mindestens einen Transportroboter, der in einem Transportgehäuse angeordnet ist, als Einzel-Module umfasst. Der Transportroboter ermöglicht den Transport der zu bearbeitenden Halbleiterscheiben zwischen dem Belademodul und der jeweiligen Prozessstation zur Bearbeitung der Halbleiterscheiben und/oder der mindestens einen Vermessstation zum Vermessen der Halbleiterscheiben. Die Erfindung betrifft die besondere Anordnung der Justage-/Kühl-Station innerhalb der Stationsanordnung, so dass ein möglichst geringer Platzbedarf der einzelnen Module innerhalb der Stationsanordnung und somit eine platzsparende Bauweise der Stationsanordnung insgesamt resultiert.

Zudem betrifft die vorliegende Erfindung ein entsprechendes Bearbeitungsverfahren sowie Vermessverfahren für Halbleiterscheiben.

Aus dem Stand der Technik bekannte Stationsanordnungen für die Bearbeitung von Halbleiterscheiben umfassen in der Regel ein Belademodul, eine oder mehrere Prozessstationen sowie eine Transportkammer, in der ein Transportroboter für den Transport der Halbleiterscheiben zwischen den einzelnen Modulen angeordnet ist. Derartige Stationsanordnungen sind beispielsweise in Munekazu Komiya, Vacuum Platform Technology for 450 mm; RORZE Corporation; http://www.sematech.org/meetings/archives/symposia/9028/Session7_450mm /Komiya_Munekazu.pdf gezeigt. Ebenso sind entsprechende Stationsanordnungen in Brooks; Fabexpress Sytems (FX); http://www.brooks.com/pages/123_fabexpress_systems_fx_.cfm; 20.10.2011 beschrieben.

In der Großserienfertigung wird das Belademodul für den Transportbehälter meist durch ein Modul ersetzt, das mehrere Transportbehälter zur gleichen Zeit bedienen kann ― ein sogenanntes Equipment Front-End Module (EFEM). Ein solches EFEM ist über Pufferstationen mit der Transportkammer verbunden und besitzt einen weiteren (eigenen) Handhabungsroboter. Aufgrund seiner Größe bietet es ausreichend Platz für Justage- und/oder Kühlstationen, der auch entsprechend genutzt wird. Der Einsatz eines EFEM lohnt sich nur, wenn ein hoher Durchsatz erreicht werden soll. Nur für die Integration von Justage- und/oder Kühlstationen sind die Kosten für ein EFEM zu hoch.

Die vertikale Anordnung einer Kühlstation ist von mindestens einem Hochtemperatur-Prozessgerät bekannt, bei dem die Kühlstation oberhalb der eigentlichen Prozessstation angebracht ist und durch den Transportroboter bedient werden kann. In dieser Anwendung ist die Kühlstation allerdings prozessgerätbezogen und steht anderen Prozessen nicht zur Verfügung.

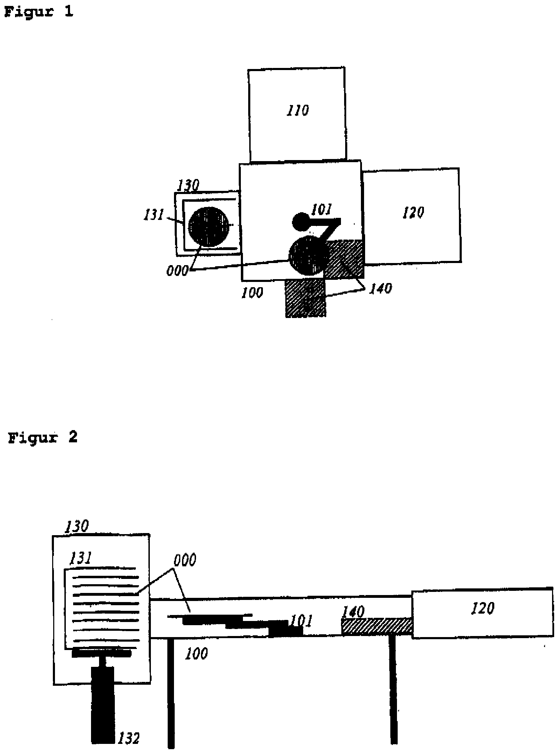

Die Anordnung der einzelnen Module entsprechend aus dem Stand der Technik bekannter Stationsanordnungen sei nachfolgend anhand der Figuren 1 und 2 näher verdeutlicht.

Figur 1 zeigt eine Stationsanordnung zur Bearbeitung von Halbleiterscheiben (d.h. Halbleiterwafern), wie sie aus dem Stand der Technik bekannt ist. Figur 1 zeigt dabei eine Aufsicht auf eine entsprechende Stationsanordnung, während Figur 2 eine Seitenansicht derselben Stationsanordnung darstellt. Die Seitenansicht, die in Figur 2 dargestellt ist, repräsentiert die Blickrichtung auf die Stationsanordnung der Figur 1 von der Seite.

Figur 1 zeigt eine Stationsanordnung zur Bearbeitung von Halbleiterscheiben, die ein Belademodul 130 umfasst, in dem die Halbleiterscheiben 000 bevorratet werden können. Das Belademodul 130 ist dabei beispielsweise derart ausgebildet, dass es einen Transportbehälter 131, in dem die Halbleiterscheiben 000 einsortiert sind, aufnehmen kann. Wie aus Figur 2 ersichtlich, können die Halbleiterscheiben 000 gestapelt an entsprechenden Positionen im Transportbehälter 131 bevorratet sein. Der Transportbehälter 131 kann dabei beispielsweise mittels eines Liftes 132 höhenverstellbar innerhalb des Belademoduls 130 für den Transportbehälter 131 gelagert sein. Kernstück der Stationsanordnung ist dabei eine Transportkammer 100, die einen Roboter 101 umfasst. Der Roboter 101 weist dabei bspw. eine Greifvorrichtung auf, mit der aus dem Transportbehälter 131 eine Halbleiterscheibe 000 entnommen werden und den weiteren Modulen der Stationsanordnung zugeführt werden kann. Das Belademodul 130 für den Transportbehälter bzw. der Transportbehälter 131 sind dabei direkt an die Transportkammer 100 angeflanscht und stehen in funktionaler Verbindung mit der Transportkammer, d.h. zwischen Transportkammer 100 und dem Belademodul 130 für den Transportbehälter 131 bzw. den Transportbehälter 131 ist eine entsprechend große Öffnung vorhanden oder ermöglichbar, die das Durchführen einer Halbleiterscheibe 000 mittels des Roboters 101 ermöglicht.

Im Beispielsfalle der Figur 1 weist die Transportkammer 100 einen quadratischen Grundriss auf, wobei das Belademodul 130 für den Transportbehälter 131 an einer Seite der Transportkammer 100 angeordnet ist. An zwei weiteren Seiten der Transportkammer 100 sind zwei Prozessstationen 110 und 120 angeordnet; diese Prozessstationen dienen entsprechenden Bearbeitungsschritten für die Halbleiterscheiben 000. In den Prozessstationen 110 und 120 kann beispielsweise ein Tempern, Oxidieren, Dotieren und/oder eine Beaufschlagung mit Ätzgasen, mechanische Bearbeitung etc. an den Halbleiterscheiben 000 vorgenommen werden.
Anstelle der Prozessstationen 110, 120 können an den zwei weiteren Seiten der Transportkammer 100 auch zwei Vermessstationen 110, 120 oder jeweils eine Prozessstation 110, 120 und eine Vermessstation 110, 120 angeordnet sein (Zur besseren Übersichtlichkeit sind die Prozessstationen und die Vermessstationen in den Figuren mit den gleichen Bezugszeichen versehen.). In den Vermessstationen 110, 120 können verschiedene Messgrößen der Halbleiterscheiben 000 vermessen werden.

Vor Zuführen der Halbleiterscheiben 000 in die Prozessstationen und/oder die Vermessstationen 110 und/oder 120 ist es unter Umständen nötig, die Halbleiterscheiben 000 auszurichten bzw. zu justieren. Ebenso kann es nötig sein, die nach der Bearbeitung aus den Prozessstationen und/oder nach der Vermessung aus den Vermessstationen 110 bzw. 120 mittels des Roboters 101 entnommenen Halbleiterscheiben 000 erneut zu justieren und/oder zu kühlen. Für diese Zwecke weist die Stationsanordnung gemäß Figur 1 bzw. Figur 2 eine Justage-/Kühlstation 140 auf, mit der die Halbleiterscheiben 000 ausgerichtet und/oder gekühlt werden können. Die Justage-/Kühlstation kann zur Ausrichtung bzw. zur Justage der Halbleiterscheiben 000 entsprechende mechanische Mittel aufweisen, mit denen die Halbleiterscheiben 000 z.B. gedreht werden können. Ebenso kann die Justage-/Kühlstation Mittel aufweisen, mit denen eine Kühlung der Halbleiterscheiben 000, die beispielsweise in den Prozessstationen 110 und/oder 120 getempert wurden, ermöglichen. Die Justage-/Kühlstation kann dabei eine der zuvor genannten Funktionen, d.h. Justage oder Kühlen bzw. beide Funktionen, d.h. Justage und Kühlen der Halbleiterscheiben 000 übernehmen.

Gemäß der aus dem Stand der Technik bekannten Stationsanordnung ist die Justage-/Kühlstation 140 entweder an einer freien Seite der Transportkammer 100 (d.h. der Seite, die nicht durch ein Belademodul 130 für den Transportbehälter 131 oder Prozessstationen und/oder Vermessstationen 110 bzw. 120 belegt ist) angeordnet; eine weitere, aus dem Stand der Technik bekannte Anordnung der Justage-/Kühlstation 140 liegt dabei innerhalb der Transportkammer 100.

Bei einer Positionierung der Justage-/Kühlstation 140 an einer freien Seite der Transportkammer, wie dies beispielsweise in den Figuren 1 und 2 dargestellt ist, geht wertvoller Platz verloren, der sonst für eine weitere Prozessstation und/oder Vermessstation genutzt werden könnte.

Bei einer Positionierung der Justage-/Kühlstation 140 innerhalb der Transportkammer 100, wie dies beispielsweise in den Figuren 1 und 2 dargestellt ist, und somit im unmittelbaren Handhabungsbereich des Transportroboters 101 muss die Transportkammer 100 über den eigentlichen Platzbedarf des Transportroboters 101 hinaus vergrößert werden. Dieses Problem tritt insbesondere dann auf, wenn große Halbleiterscheibengrößen, d.h. Halbleiterscheiben mit großem Durchmesser, beispielsweise über 200 mm, insbesondere über 300 mm oder über 450 mm Durchmesser, bearbeitet werden soll. Die Anordnung der Justage-/Kühlstation 140 innerhalb der Transportkammer 100 ist somit nur bis zu einer gewissen Halbleiterscheibengröße praktikabel, da ansonsten die Transportkammer 100 unnötig groß gebaut werden muss.

Die Prozesse finden häufig nicht bei Atmosphärendruck, sondern im Vakuum statt. Entsprechend werden dann der Transportroboter und der Transportbehälter in je eigenen Kammern gekapselt, um jeweils den Druck entsprechend den Erfordernissen anpassen zu können. Dadurch verschärft sich noch das Platzproblem, da z.B. bei einer Unterbringung der Stationen in der Transportkammer diese vergrößert werden muss.

Kommt die hier beschriebene Anordnung in einem Reinraum zum Einsatz, wie er üblicherweise in der Halbleiterfertigung verwendet wird, so verschärft sich das Problem, da Reinraumfläche extrem teuer ist.

Aufgabe der vorliegenden Erfindung ist es somit, eine Stationsanordnung zur Bearbeitung von Halbleiterscheiben anzugeben, die möglichst platzsparend gebaut ist. Zudem ist es Aufgabe der vorliegenden Erfindung, ein Bearbeitungsverfahren sowie ein Vermessungsverfahren für Halbleiterscheiben anzugeben, das eine möglichst effiziente Verfahrensführung ermöglicht.

Diese Aufgabe wird bezüglich der Stationsanordnung mit den Merkmalen des Patentanspruchs 1, bezüglich eines Bearbeitungsverfahrens für Halbleiterscheiben mit den Merkmalen des Patentanspruchs 10 sowie bezüglich eines Vermessungsverfahrens für Halbleiterscheiben mit den Merkmalen des Patentanspruchs 12 gelöst, wobei die jeweiligen abhängigen Patentansprüche vorteilhafte Weiterbildungen darstellen.

Erfindungsgemäß wird somit eine Stationsanordnung zur Bearbeitung von Halbleiterscheiben bereitgestellt, wobei die Stationsanordnung die folgenden Module als Mindestbestandteile aufweist:
a) mindestens ein Belademodul zur Bevorratung von Halbleiterscheiben,
b) mindestens eine Prozessstation zum Bearbeiten der Halbleiterscheiben und/oder mindestens eine Vermessstation zum Vermessen der Halbleiterscheiben,
c) mindestens einer Justage-/Kühl-Station und
d) mindestens einen in einer Transportkammer angeordneten Transportroboter, der einen Transport der Halbleiterscheiben zwischen dem mindestens einen Belademodul, der mindestens einen Prozessstation und/oder der mindestens einen Vermessstation und der mindestens einen Justage-/Kühl-Station ermöglicht,.

Die erfindungsgemäße Stationsanordnung zeichnet sich dadurch aus, dass das mindestens eine Belademodul, die mindestens eine Prozessstation und/oder die mindestens eine Vermessstation, die mindestens eine Justage-/Kühl-Station und die Transportkammer räumlich so zueinander angeordnet sind, dass
die Projektion des Transportwegs der mittels des Transportroboters vom mindestens einen Belademodul in eine Justage-/Kühl-Station transportierten Halbleiterscheibe auf eine Transportebene und/oder die Projektion des Transportwegs der mittels des Transportroboters von einer Justage-/Kühl-Station in die mindestens eine Vermessstation transportierten Halbleiterscheibe auf eine Transportebene je einen geschlossenen Weg beschreiben kann,
und/oder
die Projektion des Transportwegs der mittels des Transportroboters vom mindestens einen Belademodul über eine Justage-/Kühl-Station in die Transportkammer transportierten Halbleiterscheibe auf eine Transportebene und/oder die Projektion des Transportwegs der mittels des Transportroboters von der Transportkammer über eine Justage-/Kühl-Station in die mindestens eine Prozessstation und/oder die mindestens eine Vermessstation transportierten Halbleiterscheibe auf eine Transportebene je einen direkten Weg beschreiben kann.

Die zuvor beschriebene Anordnung der einzelnen Module der Stationsanordnung ermöglicht somit eine äußerst vorteilhafte platzsparende Anordnung der einzelnen Module zur gesamten Stationsanordnung.

Es ist ersichtlich, dass damit das beschriebene Platzproblem nachhaltig gelöst wird:
- Die Transportkammer muss mit ihren Ausmaßen nur noch dem Transportroboter ausreichend Bewegungsspielraum geben.
- Der Raum um die Transportkammer steht ausschließlich produktiven Prozessstationen bzw. Vermessstationen zur Verfügung.

In der erfindungsgemäßen Stationsanordnung ist somit zumindest eine der oben genannten Bedingungen realisiert, nämlich:
- eine Halbleiterscheibe kann auf geschlossenem Weg von einem Transportbehälter in eine Justage-/Kühlstation transportiert werden,
- eine Halbleiterscheibe kann auf geschlossenem Weg von einer Justage/Kühlstation in eine Vermessstation transportiert werden,
- eine Halbleiterscheibe kann auf direktem Weg von einem Transportbehälter über eine Justage-/Kühlstation in das Transportgehäuse transportiert werden, und/oder
- eine Halbleiterscheibe kann auf direktem Weg vom Transportgehäuse über eine Justage-/Kühlstation in mindestens eine Prozessstation bzw. eine Vermessstation transportiert werden.

Die zuvor beschriebenen Richtungen des Transportweges der Halbleiterscheibe sind dabei auch umkehrbar, die Bewegungsrichtung der Halbleiterscheibe dient lediglich der Definition des zurückgelegten Weges der Halbleiterscheibe und somit der zwangsläufig sich hieraus ergebenden Anordnungen der Einzelmodule.

Erfindungsgemäß wird unter der Projektion des Transportweges auf eine Transportebene der Halbleiterscheibe die Trajektorie der Halbleiterscheibe verstanden, die beim Transport aus dem Transportbehälter in die jeweiligen Prozessstationen bzw. die Justage-/Kühlstationen zurückgelegt wird. Die Transportebene entspricht dabei der Ebene, die bei Aufsicht auf die Stationsanordnung resultiert. Eine entsprechende Aufsicht ist beispielsweise in Figur 1 dargestellt, die Ansicht repräsentiert somit die Transportebene.

Unter einem geschlossen Weg, der sich bei Projektion des Transportweges der zu bearbeitenden und/oder zu vermessenden Halbleiterscheibe auf die Transportebene ergibt, wird erfindungsgemäß ein Weg verstanden, dessen Anfangs- und Endpunkt in Projektion auf die Transportebene im Wesentlichen zusammenfallen oder vollständig zusammenfallen. Bei einem vollständigen Zusammenfallen kommt die Halbleiterscheibe somit in Projektion deckungsgleich an genau der gleichen Stelle zum Ruhen, an der sie zuvor entnommen wurde. Unter im Wesentlichen zusammenfallen wird dabei verstanden, dass die beiden Positionen der Halbleiterscheiben im Anfangs- und Endzustand in Projektion auf die Transportebene zumindest noch bereichsweise eine Überlappung aufweisen. Gemäß dieser Ausführungsform der vorliegenden Erfindung ist es somit möglich, die zu bearbeitende und/oder zu vermessende Halbleiterscheibe zwischen Transportbehälter und Justage-/Kühlstation und/oder zwischen Justage-/Kühlstation und einer der Vermessstationen auf dem zuvor genannten geschlossenen Weg zu transportieren, d.h. die entsprechenden Module der Stationsanordnung weisen einen entsprechenden räumlichen Bezug zueinander auf. Eine bevorzugte Ausführungsform sieht vor, dass auf dem geschlossenen Weg die Transportkammer durchlaufen wird.

Erfindungsgemäß wird unter einem direkten Weg, der bei Projektion des Transportweges der zu bearbeitenden und/oder zu vermessenden Halbleiterscheibe auf die Transportebene bei Transport der Halbleiterscheibe vom Transportbehälter über die Justage-/Kühlstation in das Transportgehäuse und/oder vom Belademodul über eine Justage-/Kühlstation in eine Prozessstation und/oder eine Vermessstation eine Trajektorie verstanden, die einen direkten Transport zwischen den zuvor genannten Modulen ohne größere Richtungsänderung der Transportrichtung bei Durchgang durch die Justage/Kühlstation ermöglicht. Dabei beträgt die Änderung der Transportrichtung hierbei weniger als 10°, weiter vorzugweise weniger als 5°. Insbesondere wird die zu bearbeitende Halbleiterscheibe bei einem Transport auf direktem Weg geradlinig oder im Wesentlichen geradlinig zwischen Anfangs- und Endpunkt bewegt, ohne dass größere Richtungsänderungen oder Bewegungen auf einer kreisförmigen oder ovalen Bahn vorgesehen sind.

Die erfindungswesentlichen Merkmale des Arrangements der einzelnen Module, so dass die zuvor genannten Wegführungen der Halbleiterscheiben möglich werden, sind aus dem Stand der Technik nicht bekannt, dies wird nachfolgend nochmals anhand der Ausführungen der Figur 1, die Stationsanordnung gemäß dem Stand der Technik skizziert, dargestellt. Für den Fall, dass eine Halbleiterscheibe 000 dem Transportbehälter 131 mittels des Roboters 101 entnommen und zunächst vor Bearbeitung in einer Prozessstation oder vor der Vermessung in einer Vermessstation 110 bzw. 120 in einer Justage/Kühlstation 140 justiert werden soll, wird mittels des Roboters 101 eine Halbleiterscheibe 000 dem innerhalb des Belademoduls 130 angeordneten Transportbehälters 131 entnommen und der Justage-/Kühlstation 140 zugeführt. Sowohl für den Fall, dass die Justage-/Kühlstation innerhalb der Transportkammer 100 bzw. an einer Seite der Transportkammer 100 angeordnet ist, erfolgt die Wegführung der Halbleiterscheibe 000 so, dass nach Ablage der Halbleiterscheibe 000 auf die Justage-/Kühlstation diese der Justage/Kühlstation 140 unter Richtungsänderung der Trajektorie der Halbleiterscheibe 000 wieder entnommen und den Prozessstationen oder den Vermessstationen 110 und 120 zugeführt werden muss. Die Wegführung ist somit nachteilig, ebenso geht wertvoller Platz verloren, da die Stationsanordnung entsprechend groß ausgelegt werden muss. Das Gleiche ist der Fall, wenn die Halbleiterscheibe 000 nach Bearbeitung in den Prozessstationen oder nach Vermessung in den Vermessstationen 110 bzw. 120 beispielsweise zur Abkühlung der Justage-/Kühlstation 140 erneut zugeführt werden muss und im Anschluss wieder im Transportbehälter 131 verstaut werden soll. In jedem Falle folgt die Führung, d.h. die Trajektorie bzw. der Weg, den die Halbleiterscheibe 000 bei Projektion auf die Transportebene (siehe Definition oben) zurücklegt, derart, dass bei Überführung der Halbleiterscheibe 000 vom Transportbehälter 131 in die Justage-/Kühlstation bzw. von der Justage/Kühlstation 140 in den Transportbehälter 131 keinen geschlossenen Weg (wie er erfindungsgemäß verstanden wird) darstellt, d.h. der Anfangs- und der Endpunkt der projizierten Trajektorie zusammenfallen.

Ebenso wenig ist bei Durchlaufen der Justage-/Kühlstation bei Überführung einer Halbleiterscheibe 000 vom Transportbehälter 131 in die jeweiligen Prozessstationen oder Vermessstationen 110 bzw. 120 eine direkte Wegführung der zu bearbeitenden oder zu vermessenden Halbleiterscheibe 000 möglich, da bei Einführen der Halbleiterscheibe 000 in die Justage-/Kühlstation 140 und erneuten Entnahme hieraus stets ein kompletter Richtungswechsel (d.h. unter Richtungsumkehr, 180°) (beim Ein- und nachfolgendem Ausführung der Halbleitscheibe 000 in bzw. aus der Justage-/Kühlstation) erfolgen muss. Dies führt jedoch dazu, dass die Stationsanordnungen aus dem Stand der Technik äußert voluminös ausfallen.

Die erfindungsgemäße Stationsanordnung, wie vorstehend beschrieben, ermöglicht somit eine äußerst kompakte Anordnung der Module innerhalb der Stationsanordnung und zudem eine einfache Verfahrensführung bei der Überführung der einzelnen Halbleiterscheiben in die jeweiligen Module der Stationsanordnung.

Für die Bearbeitung von Halbleiterscheiben müssen diese aus einem Transportbehälter entnommen, justiert und in eine oder nacheinander mehrere Prozessstation(en) oder Vermessstation(en) verbracht werden. Nach der Prozessierung oder Vermessung erfolgt der Rücktransport in den Transportbehälter; je nach durchgeführtem Prozess oder durchgeführter Vermessung ist ein Zwischenschritt zum Abkühlen der Halbleiterscheiben notwendig.

Diese Schritte erfolgen im Produktionsumfeld und häufig auch im Feld der Forschung und Entwicklung automatisiert mithilfe eines oder mehrerer Roboter für die Entnahme und den Transfer der Halbleiterscheiben, sowie einer Justage-Station zum Justieren der Halbleiterscheiben und einer Abkühlstation zum Kühlen der Halbleiterscheiben:
- Der Transportbehälter beinhaltet eine oder mehrere Halbleiterscheiben, die beispielsweise übereinander angeordnet sind. Die Auswahl einer Halbleiterscheibe erfolgt durch vertikale Bewegung entweder des Roboters oder eines mechanischen Lifts, auf dem der Transportbehälter gelagert ist.
- Auf der Justage-Station werden die Halbleiterscheiben z.B. mittig justiert. Zusätzlich oder alternativ hierzu kann die Halbleiterscheibe durch Drehung so ausgerichtet werden, dass die an jeder Halbleiterscheibe angebrachte Markierung (z.B. Notch, Flat oder Strukturen auf der Halbleiterscheibe) eindeutig ausgerichtet ist. Durch diese Justage wird gewährleistet, dass jede Halbleiterscheibe richtig positioniert und ausgerichtet in die Scheibenaufnahme der Prozessstation oder der Vermessstation verbracht werden kann.
- Auf der Kühlstation werden die Halbleiterscheiben abgekühlt. Nachdem die Halbleiterscheibe eine festgelegte Temperatur erreicht hat, erfolgt der Weitertransport.
- Justage- und Kühlstation können integriert sein, so dass eine kombinierte Station beide Funktionen ausübt.

Eine bevorzugte Ausführungsform der vorliegenden Erfindung sieht vor, dass mindestens ein Belademodul in Transportebene mit der Transportkammer verbunden ist, so dass eine zu bearbeitende oder zu vermessende Halbleiterscheibe vom Belademodul über die Verbindung mittels des Transportroboters in die Transportkammer transportiert werden kann. In diesem Falle kann die Justage-/Kühlstation an anderer Stelle der Stationsanordnung integriert sein, damit sich die oben beschriebene Anordnung der einzelnen Module zueinander ergibt. Dies kann beispielsweise durch Anordnung der Justage/Kühlstation zwischen der Transportkammer und einer Prozessstation und/oder Vermessstation sein, auf diese Ausführung wird nachfolgend noch detaillierter eingegangen.

Alternativ hierzu ist es möglich und bevorzugt, dass eine Justage-/Kühl-Station zwischen mindestens einem Belademodul und der Transportkammer, das mindestens eine Belademodul und die Transportkammer in Transportrichtung verbindend angeordnet ist, so dass eine zu bearbeitende Halbleiterscheibe vom Belademodul durch die Justage-/Kühl-Station mittels des Transportroboters in die Transportkammer transportiert werden kann.

Eine weitere bevorzugte Ausführungsform der vorliegenden Erfindung, die in Kombination mit den zuvor genannten bevorzugten Ausführungsformen, aber auch alternativ hierzu vorliegen kann ist gegeben, wenn die Transportkammer in Transportebene mit mindestens einer Prozessstation und/oder mindestens einer Vermessstation verbunden ist, so dass eine zu bearbeitende oder zu vermessende Halbleiterscheibe von der Transportkammer über die Verbindung mittels des Transportroboters in die mindestens einer Prozessstation und/oder in die mindestens eine Vermessstation transportiert werden kann. In diesem Falle kann die Justage-/Kühlstation an anderer Stelle der Stationsanordnung integriert sein, damit sich die oben beschriebene Anordnung der einzelnen Module zueinander ergibt. Dies kann beispielsweise durch Anordnung der Justage-/Kühlstation zwischen dem Belademodul und der Transportkammer sein, wie obenstehend beschrieben.

Alternativ hierzu ist es ebenso möglich, dass eine Justage-/Kühl-Station zwischen der Transportkammer und mindestens einer Prozessstation, die Transportkammer und die mindestens eine Prozessstation in Transportrichtung verbindend angeordnet ist, so dass eine zu vermessende Halbleiterscheibe von der Transportkammer durch die durch die Justage-/Kühl-Station mittels des Transportroboters in die mindestens eine Vermessstation transportiert werden kann.

Zusätzlich oder alternativ zur vorstehend beschriebenen Ausführungsform ist es ebenso möglich, dass eine Justage-/Kühl-Station zwischen der Transportkammer und mindestens einer Vermessstation, die Transportkammer und die mindestens eine Vermessstation in Transportrichtung verbindend angeordnet ist, so dass eine zu bearbeitende Halbleiterscheibe von der Transportkammer durch die durch die Justage-/Kühl-Station mittels des Transportroboters in die mindestens einer Prozessstation transportiert werden kann.

Die zuvor beschriebenen bevorzugten Ausführungsformen, bei denen die Justage-/Kühlstation zwischen dem Belademodul und der Transportkammer und/oder zwischen dem Transportgehäuse und mindestens einer Prozessstation bzw. der mindestens einen Vermessstation angeordnet ist, ermöglicht einen direkten Transportweg einer Halbleiterscheibe zwischen den jeweiligen Modulen, die durch die Justage-/Kühlstation miteinander verbunden sind. Bei diesen Ausführungsformen kann mittels des Robotorarmes beispielsweise aus einem Transportbehälter eines Belademoduls eine Halbleiterscheibe in die Transportkammer überführt werden, bei diesem Transport wird auf direktem Wege die Justage-/Kühlstation durchlaufen, hierbei kann die Halbleiterscheibe beispielsweise auf einer Kühlvorrichtung der Justage-/Kühlstation abgelegt und gekühlt werden, die Kühlvorrichtung kann beispielsweise als entsprechend des Umrisses der Halbleiterscheibe ausgebildeter Metallblock sein. Zusätzlich oder alternativ hierzu kann die Justage-/Kühlstation ebenso mechanische Mittel zur Ausrichtung der Halbleiterscheibe aufweisen, auf die die Halbleiterscheibe mittels des Roboterarmes abgelegt werden kann. In analoger Weise kann ggf. der Transport zwischen Transportkammer und der jeweiligen Prozessstation bzw. Vermessstation gestaltet sein, wenn zwischen Transportkammer und Prozessstation oder Vermessstation eine Justage-/Kühlstation angeordnet ist. Der Transport kann selbstverständlich auch in die Gegenrichtung, d.h. von Prozessstation bzw. Vermessstation über Justage-/Kühlstation in die Transportkammer bzw. von Transportkammer über eine Justage/Kühlstation in ein Belademodul auf direktem Weg erfolgen.

Insbesondere ist bei der erfindungsgemäßen Stationsanordnung bevorzugt, wenn die mindestens eine Justage-/Kühlstation außerhalb der Transportkammer angeordnet ist.

Bei einer Ausführungsform der erfindungsgemäßen Stationsanordnung, bei der die Justage-/Kühlstation beispielsweise zwischen Belademodul und Transportkammer und/oder zwischen Transportkammer und einer Prozessstation bzw. einer Vermessstation angeordnet ist, kann es vorgesehen sein, dass die Justage-/Kühlstation zwar entsprechend dimensioniert ist, dass eine Halbleiterscheibe in der Breite vollständig durch sie hindurchgeführt werden kann, jedoch hinsichtlich ihrer Länge verkürzt ist, so dass beispielsweise bei Entnahme einer Halbleiterscheibe aus dem Belademodul und bei Durchführung bzw. Ablage der Halbleiterscheibe auf der Justage-/Kühlstation vor Überführung in die Transportkammer nicht bezüglich ihrer Länge vollständig in der Justage-/Kühlstation untergebracht werden kann. In diesem Falle ist es insbesondere vorteilhaft, wenn die Länge der Justage-/Kühlstation das 0,2- bis 0,95fache, insbesondere das 0,2- bis 0,5-fache der Länge einer eingesetzten Halbleiterscheibe aufweist, wobei die Halbleiterscheibe in angrenzende Module ragen kann. Hierdurch wird der Platzbedarf zusätzlich verringert.

Eine weiter bevorzugte Ausführungsform, die ebenso alternativ oder zusätzlich zu den vorgenannten Ausführungsformen gegeben sein kann, sieht vor, dass mindestens eine Justage-/Kühl-Station zusammen mit einem Belademodul oder einem Transportbehälter eines Belademoduls und/oder mit einer Vermessstation einen Stapel bildet, der im Wesentlichen senkrecht oder senkrecht zur Transportebene ausgebildet ist.

Die zuvor beschriebenen Ausführungsformen ermöglichen einen geschlossenen Weg des Transportes zwischen Belademodul und Justage-/Kühlstation bzw. zwischen Justage-/Kühlstation und Vermessstation. Eine entsprechende Überführung einer Halbleiterscheibe beispielsweise von einem Belademodul in eine Justage-/Kühlstation, die in diesem Falle mit dem Belademodul bzw. den Transportbehälter des Belademoduls einen Stapel bildet, erfolgt dabei derart, dass eine Halbleiterscheibe mittels des Roboters dem Transportbehälter des Belademoduls entnommen wird und relativ versetzt hierzu, d.h. senkrecht zur Transportebene versetzt, in die Justage-/Kühlstation überführt wird, so dass in Projektion auf die Transportebene der Anfangs- und der Endpunkt der Halbleiterscheibe in diesem Falle zusammenfallen. Der relative Versatz senkrecht zur Transportebene der Halbleiterscheibe kann dabei durch relative Bewegung des Stapels und/oder des Roboterarmes senkrecht zur Transportebene erfolgen, beispielsweise kann der Stapel, der aus Transportbehälter und Justage-/Kühlstation gebildet ist, durch einen Mechanismus senkrecht zur Transportebene verschoben werden oder der Roboterarm entsprechend beweglich senkrecht zur Transportebene ausgebildet sein. Auf die gleiche Art und Weise kann eine Überführung der Halbleiterscheibe zwischen Justage/Kühlstation und Vermessstation erfolgen, für den Fall, dass die Justage/Kühlstation mit der Vermessstation einen Stapel bildet.

Eine bevorzugte Ausführungsform hierzu sieht vor, dass mindestens eine Justage-/Kühl-Station zusammen mit einem Belademodul oder einem Transportbehälter eines Belademoduls einen Stapel bildet, wobei die Justage-/Kühl-Station am oberen und/oder unteren Ende und/oder im Inneren des Stapels ausgebildet ist.

Ebenso ist es möglich, dass die Stationsanordnung mindestens zwei Justage/Kühlstationen umfasst, wobei mindestens eine Justage-/Kühl-Station zusammen mit einer Prozessstation einen Stapel bildet, und diese Justage/Kühl-Station am oberen und/oder unteren Ende des Stapels ausgebildet ist.

Im Falle der zuvor beschriebenen Stapelbauweise wird die Translation senkrecht zur Transportebene bevorzugt dadurch bewerkstelligt, dass der Stapel statisch gelagert ist und der Transportroboter eine senkrecht zur Transportebene verlaufende Bewegungskomponente umfasst und/oder der Stapel senkrecht zur Transportebene verfahrbar gelagert ist. Der Stapel kann beispielsweise über einen Lift bzw. einen Transportmechanismus verfügen, mit dem der Stapel senkrecht zur Transportebene verschoben bzw. versetzt werden kann.

In einer weiteren bevorzugten Ausführungsform sind die einzelnen Module der Stationsanordnung, d.h. das mindestens eine Belademodul, die mindestens eine Prozessstation und/oder die mindestens eine Vermessstation, die mindestens eine Justage-/Kühl-Station und/oder die Transportkammer jeweils von den anderen Modulen hermetisch verschließbar ausgebildet, sodass der Luftdruck jeweils verschieden regelbar ist. Der Transportbehälter des Belademoduls kann dabei beispielsweise im Belademodul gelagert werden. In diesem Falle kann ebenso das Belademodul gegenüber der Transportkammer hermetisch verschließbar sein. Zudem kann der Transportbehälter in das Belademodul eingeführt bzw. dieser entnommen werden.

Die vorliegende Erfindung betrifft ebenso ein Bearbeitungsverfahren für Halbleiterscheiben, bei dem eine in einem Belademodul zur Bevorratung von Halbleiterscheiben bevorratete Halbleiterscheibe oder sich nach einer Vermessung in einer Vermessstation befindlichen Halbleiterscheibe mittels eines Transportroboters entnommen, mindestens einer Prozessstation zum Bearbeiten der Halbleiterscheiben zugeführt, in der mindestens einen Prozessstation bearbeitet, anschließend der Prozessstation entnommen und in ein Belademodul rückgeführt oder in eine Vermessstation zur Vermessung einer Messgröße der Halbleiterscheibe geführt wird, wobei die Halbleiterscheibe nach Entnahme aus dem Belademodul oder der Vermessstation und vor Zuführung in die mindestens eine Prozessstation und/oder nach Entnahme aus der mindestens einen Prozessstation und vor Rückführung in ein Belademodul oder Führung in eine Vermessstation mittels des Transportroboters durch mindestens eine Justage-/Kühl-Station transportiert und dort justiert und/oder gekühlt wird.

Das erfindungsgemäße Verfahren zeichnet sich dadurch aus, dass die Projektion des Transportwegs der mittels des Transportroboters vom mindestens einen Belademodul oder von einer Vermessstation in eine Justage-/KühlStation transportierten Halbleiterscheibe auf eine Transportebene je einen geschlossenen Weg beschreibt, und/oder dass die Projektion des Transportwegs der mittels des Transportroboters vom mindestens einen Belademodul oder von einer Vermessstation über eine Justage-/Kühl-Station in die Transportkammer transportierten Halbleiterscheibe auf eine Transportebene und/oder die Projektion des Transportwegs der mittels des Transportroboters von der Transportkammer über eine Justage-/Kühl-Station in die mindestens eine Prozessstation transportierten Halbleiterscheibe auf eine Transportebene je einen direkten Weg beschreibt.

Das erfindungsgemäße Bearbeitungsverfahren beruht somit ebenso auf den obenstehend erläuterten Prinzipien. Das erfindungsgemäße Bearbeitungsverfahren ist ebenso dann realisiert, wenn die umgekehrten Transportwege anstelle der explizit oben angegebenen Transportwege durchlaufen werden, d.h. wenn die Projektion des Transportweges der mittels des Transportroboters von mindestens einer Justage-/Kühlstation in einen Transportbehälter oder eine Vermessstation transportierten Halbleiterscheibe auf eine Transportebene und/oder die Projektion des Transportweges der mittels des Transportroboters von mindestens einer Prozessstation in eine Justage-/Kühlstation transportierten Halbleiterscheibe auf eine Transportebene je einen geschlossenen Weg beschreibt
und/oder
die Projektion des Transportweges der mittels des Transportroboters von der Transportkammer über eine Justage-/Kühlstation in mindestens einen Transportbehälter oder eine Vermessstation transportierten Halbleiterscheibe auf eine Transportebene und/oder die Projektion des Transportweges der mittels des Transportroboters von mindestens einer Prozessstation über eine Justage/Kühlstation in eine Transportkammer transportierten Halbleiterscheibe auf eine Transportebene je einen direkten Weg beschreibt.

Das erfindungsgemäße Bearbeitungsverfahren ermöglicht somit eine möglichst platzsparende Bewegung des Transportweges der Halbleiterscheibe mittels des Roboterarmes, zugleich ist eine möglichst effiziente Verfahrensführung, bei der zum Teil mehrere Arbeitsschritte auf einem einzigen Transportweg erledigt werden können, gewährleistet.

Eine bevorzugte Ausführungsform des Verfahrens sieht vor, dass die Bearbeitung der Halbleiterscheiben 000 in der mindestens einen Prozessstation 110, 120 ein Temperieren, Oxidieren, Sputtern, Beschichten, Ätzen, Oberflächenstrukturieren und/oder Kombinationen hieraus umfasst.

Zudem betrifft die vorliegende Erfindung ein Vermessungsverfahren für Halbleiterscheiben, bei dem eine in einem Belademodul zur Bevorratung von Halbleiterscheiben bevorratete Halbleiterscheibe mittels eines Transportroboters entnommen, mindestens einer Vermessstation zum Vermessen mindestens einer Messgröße der Halbleiterscheiben zugeführt, in der mindestens einen Vermessstation mindestens eine Messgröße der Halbleiterscheiben vermessen, anschließend die Halbleiterscheibe der Vermessstation entnommen und in ein Belademodul rückgeführt wird, wobei die Halbleiterscheibe nach Entnahme aus dem Belademodul und vor Zuführung in die mindestens eine Vermessstation und/oder nach Entnahme aus der mindestens einen Vermessstation und vor Rückführung in ein Belademodul mittels des Transportroboters durch mindestens eine Justage-/Kühl-Station transportiert und dort justiert und/oder gekühlt wird.

Das erfindungsgemäße Vermessungsverfahren zeichnet sich dadurch aus, dass die Projektion des Transportwegs der mittels des Transportroboters vom mindestens einen Belademodul in eine Justage-/Kühl-Station transportierten Halbleiterscheibe auf eine Transportebene und/oder die Projektion des Transportwegs der mittels des Transportroboters von einer Justage-/KühlStation in die mindestens eine Vermessstation transportierten Halbleiterscheibe auf eine Transportebene je einen geschlossenen Weg beschreibt, und/oder die Projektion des Transportwegs der mittels des Transportroboters vom mindestens einen Belademodul über eine Justage-/Kühl-Station in die Transportkammer transportierten Halbleiterscheibe auf eine Transportebene und/oder die Projektion des Transportwegs der mittels des Transportroboters von der Transportkammer über eine Justage-/Kühl-Station in die mindestens eine Vermessstation transportierten Halbleiterscheibe auf eine Transportebene je einen direkten Weg beschreibt.

Das erfindungsgemäße Vermessungsverfahren beruht somit ebenso auf den voranstehend beschriebenen Prinzipien für das erfindungsgemäße Bearbeitungsverfahren, nur dass anstelle eines Bearbeitungsschrittes ein Vermessungsschritt durchgeführt wird. Bearbeitungs- und Vermessungsverfahren können auch miteinander kombiniert werden, sodass das Bearbeitungsverfahren einen oder mehrere Vermessungsschritt(e) und/oder das Vermessungsverfahren einen oder mehrere Bearbeitungsschritt(e) beinhalten.

Beim Vermessungsschritt wird dabei mindestens eine physikalische Messgröße der zu vermessenden Halbleiterscheiben vermessen. Hierbei kann es sich beispielsweise um ein Vermessen der Oberflächenstrukturierung der Halbleiterscheiben, Vermessen von auf der Oberfläche dieser Halbleiterscheiben aufgebrachten Schichtdicken bzw. Zusammensetzungen der Halbleiterscheiben handeln. Für die entsprechenden Vermessungen können optische oder auch mechanische Messverfahren eingesetzt werden.

Die für die erfindungsgemäßen Verfahren verwendbaren Halbleiterscheiben können dabei im Wesentlichen oder vollständig rund, kreisförmig oder oval sein, können aber auch n-eckig, mit 3 ≤ n ≤ 10, insbesondere rechteckig, quadratisch oder hexagonal ausgebildet sein, weisen eine maximale Dimensionierung (Durchmesser) von mindestens 100 mm, bevorzugt mindestens 200 mm, insbesondere mindestens 300 mm bis 500 mm, besonders bevorzugt 450 mm auf.

Zudem können die Halbleiterscheiben (Wafer) vorprozessiert sein. Vorprozessierte Halbleiterwafer umfassen dabei bereits gewisse auf den Halbleiterwafern aufgebrachte Strukturen, wie beispielsweise strukturierte Schaltkreise, mechanische Bauelemente etc.

Zudem ist es möglich, dass im erfindungsgemäßen Bearbeitungsverfahren zumindest der Bearbeitungsschritt in der mindestens einen Prozessstation unter gegenüber bei Normalbedingungen reduziertem Druck durchgeführt wird.

Die erfindungsgemäßen Verfahren werden in vorteilhafter Weise mit einer zuvor beschriebenen Stationsanordnung durchgeführt.

Für den Fall einer kombinierten Verfahrensführung, wobei die Halbleiterscheiben sowohl prozessiert als auch vermessen werden, ist auch eine kombinierte Prozessstation denkbar, die sowohl mindestens eine Prozessstation als auch eine Vermessstation aufweist.

Anwendung findet dieser Lösungsweg bei allen Geräten, bei denen ein Transportroboter eine Halbleiterscheibe an einer Position aufnimmt und an einer anderen ablegt und dazwischen eine Ausrichtung und/oder Kühlung der Halbleiterscheibe erfolgen muss. Aufnahme- und Ablagepositionen können Prozessgeräte, Zwischenstationen oder Transportbehälter wie z.B. Standard mechanical interface (SMIF) (SEMI standard E19-1105), Front open unified pad (FOUP) oder eine Kassette sein.

Die vorliegende Erfindung wird anhand der nachfolgenden Figuren näher beschrieben, ohne die Erfindung auf die dargestellten Ausführungsformen zu beschränken.

Dabei zeigen
- Figur 3: eine erfindungsgemäße Stationsanordnung in Seitenansicht, bei der die Justage-/Kühlstation in Stapelbauweise mit dem Transportbehälter realisiert ist und
- Figur 4: eine erfindungsgemäße Stationsanordnung, bei der die Justage-/Kühlstation zwischen Transportbehälter und Transportkammer angeordnet ist.

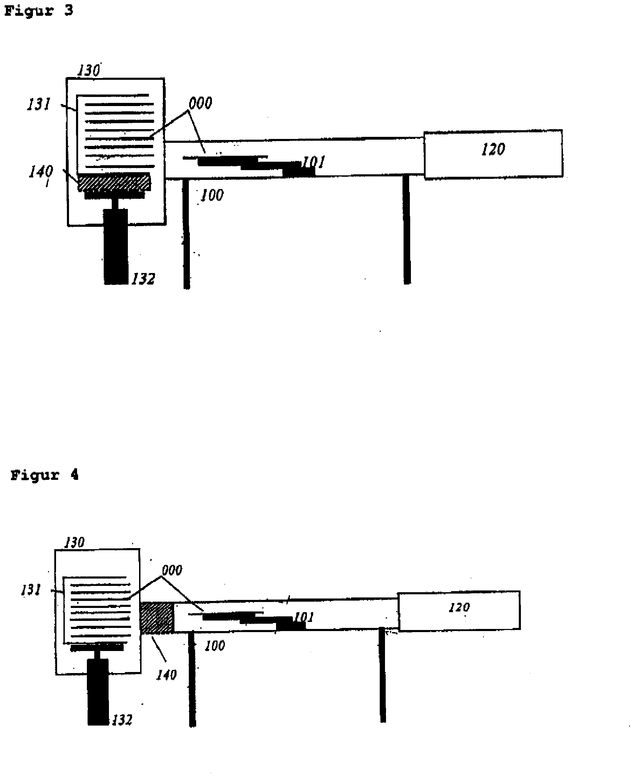

Figur 3 zeigt eine erfindungsgemäße Stationsanordnung in Seitenansicht. Die erfindungsgemäße Stationsanordnung weist dabei prinzipiell die gleichen Module auf, wie diese bereits in den Figuren 1 und 2 dargestellt wurden, dabei sind gleiche Module mit gleichen Bezugszeichen versehen. Allerdings erfolgt die Anordnung der Justage-/Kühlstation 140 auf erfindungsgemäße Art und Weise. Die erfindungsgemäße Stationsanordnung umfasst ein Belademodul 130 für einen Transportbehälter 131, wobei im Transportbehälter 131 mehrere Halbleiterscheiben 000, beispielsweise Siliciumwafer, in Stapelbauweise an dafür vorgesehen Ablagestellen gelagert sind. An das Belademodul 130 für den Transportbehälter 131 schließt sich eine Transportkammer (oder Transportgehäuse) 100 an, in der ein Transportroboter 101 angeordnet ist. Der Transportroboter 101 ist dabei derart ausgebildet, dass er eine Halbleiterscheibe 000 dem Transportbehälter 131 entnehmen kann und beispielsweise einer dem Belademodul 130 für den Transportbehälter 131 gegenüberliegenden Prozessstation und/oder Vermessstation 120 zuführen kann.

Der Grundriss der in Figur 3 dargestellten Stationsanordnung kann dabei prinzipiell genauso wie in Figur 1 ausgestaltet sein, d.h. es können neben der in Figur 3 dargestellten Prozessstation und/oder Vermessstation 120 noch weitere Prozessstationen und/oder Vermessstationen (nicht dargestellt) vorhanden sein.

Erfindungsgemäß ist nun vorgesehen, dass die Justage-/Kühlstation 140 nicht wie im Stand der Technik im Inneren der Transportkammer 100 oder an einem für ein Prozessmodul nutzbaren Platz angeordnet ist, sondern in Stapelbauweise unterhalb des Transportbehälters 131 arrangiert ist. Der aus Transportbehälter 131 und Justage-/Kühlstation 140 gebildete Stapel 131 + 140 ist dabei mittels eines Lifts 132 höhenverstellbar gelagert, so dass eine Translation bezüglich der Transportebene dieses Stapels stattfinden kann. Für den Fall, dass nun eine Halbleiterscheibe 000 der Bearbeitung zugeführt werden kann, kann diese mittels des Roboters 101 dem Transportbehälter 131 entnommen werden. Anschließend wird der Stapel 131 + 140 nach oben gefahren, so dass die Halbleiterscheibe 000 der Justage-/Kühlstation 140 zugeführt werden kann. Die dabei auf die Transportebene projizierte Trajektorie des zurückgelegten Weges der Halbleiterscheibe 000 hat dabei den gleichen Anfangs- und Endpunkt, da die Halbleiterscheibe 000 an gleicher Stelle wie in der ursprünglichen Lagerposition im Transportbehälter 131 in der Justage-/Kühlstation 140 in Projektion auf die Transportebene einnimmt.

In der Justage-/Kühlstation 140 kann anschließend beispielsweise eine Ausrichtung durch entsprechende Drehung bzw. Zentrierung der Halbleiterscheibe 000 auf eine dafür vorgesehene Position erfolgen. Anschließend erfolgt ein Überführen der Halbleiterscheibe 000 mittels des Transportroboters 101 in die Prozessstation und/oder Vermessstation 120, in der eine entsprechende Bearbeitung und/oder Vermessung der Halbleiterscheibe 000.

Nach Abschluss des Bearbeitungsschrittes und/oder Vermessungsschrittes wird die Halbleiterscheibe 000 erneut der Prozessstation und/oder Vermessstation 120 mittels des Roboters 101 entnommen und kann erneut der Justage-/Kühlstation 140 zugeführt werden; in diesem Fall kann beispielsweise ein Kühlen der noch heißen, aus der Prozessstation und/oder Vermessstation 120 kommenden Halbleiterscheibe 000 erfolgen. Der abschließende Verstauungsschritt, bei dem die Halbleiterscheibe 000 aus der Justage-/Kühlstation 140 mittels des Roboters 101 entnommen und zur Lagerung erneut dem Transportbehälter 131 zugeführt wird, erfolgt dabei auf analoge Art und Weise, wie der eingangs beschriebene Entnahmeschritt aus dem Transportbehälter 131, d.h. die auf die Transportebene projizierte Trajektorie der Halbleiterscheibe 000 repräsentiert dabei ebenso einen geschlossenen Weg, da der Ausgangspunkt, d.h. die Position der Halbleiterscheibe 000 innerhalb der Justage-/Kühlstation 140 und der Endpunkt, d.h. die Lagerposition der Halbleiterscheibe 000 im Transportbehälter 131 in Projektion auf die Transportebene die gleiche Position einnehmen.

Hieraus resultiert eine äußerst kompakte Anordnung, da die Justage/Kühlstation 140 unterhalb (oder oberhalb oder innerhalb) des Transportbehälters angeordnet sein kann und somit sämtliche Seiten der Transportkammer 100 für Prozessstationen zur Verfügung stehen. Ebenso wird durch das entsprechende Arrangement der Justage-/Kühlstation 140 erreicht, dass die Transportkammer 100 kleiner dimensioniert werden kann, so dass sie mit ihren Ausmaßen nur noch dem Transportroboter ausreichend Bewegungsspielraum geben muss.

Prinzipiell ist es alternativ oder zusätzlich zu der in Figur 3 dargestellten Ausführungsform ebenso denkbar, die Justage-/Kühlstation 140 unterhalb oder oberhalb einer Vermessstation 120 (bzw. den weiteren Vermessstationen) anzuordnen und eine Höhenverstellbarkeit der Vermessstationen zu realisieren. Ebenso ist eine Höhenverstellbarkeit des Roboters denkbar. Auf diesem Weg erfolgt eine Entnahme bzw. Zuführung der Halbleiterscheiben von der Justage-/Kühlstation 140 in eine Vermessstation 120 in analoger Weise auf geschlossenem Weg.

Zur Lösung des Platzproblems werden somit die Justage-/Kühlstationen 140 oberhalb und/oder unterhalb des Transportbehälters 131 angebracht. Dabei können die Justage-/Kühlstationen 140 Teil des Transportbehälters 131 sein, oder anderweitig innerhalb des Belademoduls 130 angebracht werden. Ist der Transportbehälter 131 statisch gelagert, so kann die neue Position der Justage-/Kühlstationen 140 durch eine erweiterte vertikale Bewegung des Transportroboters 101 erreicht werden. Ist der Transportbehälter 131 auf einem vertikal beweglichen Lift 132 gelagert, so kann die neue Position der Justage-/Kühlstationen 140 durch eine erweiterte vertikale Bewegung des Lifts 132 erreicht werden.

Figur 4 stellt eine weitere Ausführungsform einer erfindungsgemäßen Stationsanordnung dar, die auf den gleichen Modulen beruht, wie sie in den Figuren 1 bis 3 dargestellt sind. Im Unterschied zur Ausführungsform, die in Figur 3 dargestellt ist, ist bei der Stationsanordnung 4 die Justage-/Kühlstation 140 zwischen dem Belademodul 130 und der Transportkammer 100 angeordnet.

Bei Entnahme einer Halbleiterscheibe 000 aus dem Transportbehälter 131 greift der Roboterarm 101 somit durch die Justage-/Kühlstation 140 hindurch und entnimmt dem Transportbehälter 131 eine entsprechende Halbleiterscheibe 000. Beim Transport vom Transportbehälter 131 hin zur Prozessstation und/oder Vermessstation 120 durchläuft somit die Halbleiterscheibe 000 auf direktem Wege (d.h. in diesem Fall geradlinig) die Justage-/Kühlstation 140. Gemäß dieser Anordnung kann unmittelbar nach der Entnahme eine Justage der entnommenen Halbleiterscheibe erfolgen.

Alternativ aber auch zusätzlich hierzu ist es jedoch ebenso möglich, die Justage-/Kühlstation 140 zwischen der Transportkammer und einer Prozessstation und/oder Vermessstation 120 zu arrangieren, so dass beispielsweise die Zuführung der Halbleiterscheibe 000 von der Transportkammer 100 in die Prozessstation und/oder Vermessstation 120 auf direktem Wege erfolgen kann. In analoger Weise sind die umgekehrten Bewegungsrichtungen, d.h. Transportrichtungen bzw. ―wege der Halbleiterscheibe 000 ebenso direkt.

Zur Lösung des Platzproblems wird somit die Justage-/Kühlstation 140 zwischen Transportkammer 100 und Belademodul 130 oder einer Prozessstation und/oder Vermessstation 110, 120 angebracht. Die Justage-/Kühlstation 140 befindet sich im Verfahrbereich des Transportroboters 101. Die Justage/Kühlstation 140 kann ohne weitere Anpassung des Transportroboters erreicht werden.

Die Justage-/Kühlstation 140 kann aufgeteilt sein in eine Justagestation und eine Kühlstation. Die Kühlstation kann sich in dem Belademodul 130, wie in Variante a) beschrieben, befinden. Die Justagestation 140 kann zwischen der Transportkammer 100 und dem Belademodul 130 oder einer Prozessstation und/oder Vermessstation 110, 120, wie in Variante b) beschrieben, angebracht sein.

Ebenso sind Kombinationen der in Figur 3 und 4 dargestellten Ausführungsformen denkbar, beispielsweise kann sowohl eine Justage-/Kühlstation in Stapelbauweise gemäß den Ausführungen der Figur 3 angeordnet sein und zusätzlich mindestens eine weitere Justage-/Kühlstation 140 gemäß den Ausführungen der Figur 4, d.h. zwischen Belademodul 130 und Transportkammer 100 arrangiert sein. Die Justage-/Kühlstationen 140 können jeweils nur eine der genannten Funktionen, d.h. entweder nur Justage bzw. nur Kühlvorgänge realisieren, alternativ hierzu ist es jedoch ebenso möglich, dass die Justage/Kühlstationen beide Funktionen beinhalten.

## Patentansprüche

1. Stationsanordnung zur Bearbeitung und/oder Vermessung von Halbleiterscheiben (000), umfassend die folgenden Module als Mindestbestandteile:
a) mindestens ein Belademodul (130) zur Bevorratung von Halbleiterscheiben (000),
b) mindestens eine Prozessstation (110, 120) zum Bearbeiten der Halbleiterscheiben (000) und/oder mindestens eine Vermessstation (110, 120) zum Vermessen der Halbleiterscheiben (000),
c) mindestens einer Justage-/Kühl-Station (140) und
d) mindestens einen in einer Transportkammer (100) angeordneten Transportroboter (101), der einen Transport der Halbleiterscheiben (000) zwischen dem mindestens einen Belademodul (130), der mindestens einen Prozessstation (110, 120) und/oder der mindestens einen Vermessstation (110, 120) und der mindestens einen Justage-/Kühl-Station (140) ermöglicht,
**dadurch gekennzeichnet,**
**dass** das mindestens eine Belademodul (130), die mindestens eine Prozessstation (110, 120) und/oder mindestens eine Vermessstation (110, 120), die mindestens eine Justage-/Kühl-Station (140) und die Transportkammer (100) räumlich so zueinander angeordnet sind, dass
die Projektion des Transportwegs der mittels des Transportroboters (101) vom mindestens einen Belademodul (130) in eine Justage-/ Kühl-Station (140) transportierten Halbleiterscheibe (000) auf eine Transportebene und/oder die Projektion des Transportwegs der mittels des Transportroboters (101) von einer Justage-/Kühl-Station (140) in die mindestens eine Vermessstation (110, 120) transportierten Halbleiterscheibe (000) auf eine Transportebene je einen geschlossenen Weg beschreiben kann,
und/oder
die Projektion des Transportwegs der mittels des Transportroboters (101) vom mindestens einen Belademodul (130) über eine Justage-/ Kühl-Station (140) in die Transportkammer (100) transportierten Halbleiterscheibe (000) auf eine Transportebene und/oder die Projektion des Transportwegs der mittels des Transportroboters (101) von der Transportkammer (100) über eine Justage-/Kühl-Station (140) in die mindestens eine Prozessstation (110, 120) und/oder die mindestens eine Vermessstation (110, 120) transportierten Halbleiterscheibe (000) auf eine Transportebene je einen direkten Weg beschreiben kann.

2. Stationsanordnung nach Anspruch 1, **dadurch gekennzeichnet, dass**
a) mindestens ein Belademodul (130) in der Transportebene mit der Transportkammer (100) verbunden ist, so dass eine Halbleiterscheibe (000) vom Belademodul (130) über die Verbindung mittels des Transportroboters (101) in die Transportkammer (100) transportiert werden kann, oder
b) eine Justage-/Kühl-Station (140) zwischen mindestens einem Belademodul (130) und der Transportkammer (100), das mindestens eine Belademodul (130) und die Transportkammer (100) in Transportrichtung verbindend angeordnet ist, so dass eine Halbleiterscheibe (000) vom Belademodul (130) durch die Justage-/Kühl-Station (140) mittels des Transportroboters (101) in die Transportkammer (100) transportiert werden kann.

3. Stationsanordnung nach einem der vorhergehenden Ansprüche, **dadurch gekennzeichnet, dass**
a) die Transportkammer (100) in der Transportebene mit mindestens einer Prozessstation (110, 120) und/oder mindestens einer Vermessstation (110, 120) verbunden ist, so dass eine Halbleiterscheibe (000) von der Transportkammer (100) über die Verbindung mittels des Transportroboters (101) in die mindestens eine Prozessstation (110, 120) und/oder in die mindestens eine Vermessstation (110, 120) transportiert werden kann, oder
b) eine Justage-/Kühl-Station (140) zwischen der Transportkammer (100) und mindestens einer Prozessstation (110, 120) angebracht ist, die Transportkammer (100) und die mindestens eine Prozessstation (110, 120) in Transportrichtung verbindend angeordnet ist, so dass eine Halbleiterscheibe (000) von der Transportkammer (100) durch die Justage-/Kühl-Station (140) mittels des Transportroboters (101) in die mindestens eine Prozessstation (110, 120) transportiert werden kann, und/oder
c) eine Justage-/Kühl-Station (140) zwischen der Transportkammer (100) und mindestens einer Vermessstation (110, 120) angebracht ist, die Transportkammer (100) und die mindestens eine Vermessstation (110, 120) in Transportrichtung verbindend angeordnet ist, so dass eine Halbleiterscheibe (000) von der Transportkammer (100) durch die Justage-/Kühl-Station (140) mittels des Transportroboters (101) in die mindestens eine Vermessstation (110, 120) transportiert werden kann.

4. Stationsanordnung nach einem der vorhergehenden Ansprüche, **dadurch gekennzeichnet, dass** die mindestens eine Justage-/Kühlstation außerhalb der Transportkammer (100) angeordnet ist.

5. Stationsanordnung nach einem der vorhergehenden Ansprüche, **dadurch gekennzeichnet, dass** mindestens eine Justage-/Kühl-Station (140) zusammen mit einem Belademodul (130) oder einem Transportbehälter (131) eines Belademoduls (130) und/oder mit einer Vermessstation (110, 120) einen Stapel (130+140) bildet, der im Wesentlichen senkrecht oder senkrecht zur Transportebene ausgebildet ist.

6. Stationsanordnung nach vorhergehendem Anspruch, **dadurch gekennzeichnet, dass** mindestens eine Justage-/Kühl-Station (140) zusammen mit einem Belademodul (130) oder einem Transportbehälter (131) eines Belademoduls (130) einen Stapel (130+140) bildet, wobei die Justage-/Kühl-Station (140) am oberen und/oder unteren Ende und/oder im Inneren des Stapels (130+140) ausgebildet ist.

7. Stationsanordnung nach einem der vorhergehenden Ansprüche, **dadurch gekennzeichnet, dass** die Stationsanordnung mindestens zwei Justage/Kühlstationen umfasst, wobei mindestens eine Justage-/Kühl-Station (140) zusammen mit einer Prozessstation (110, 120) einen Stapel bildet, und diese Justage-/Kühl-Station (140) am oberen und/oder unteren Ende des Stapels ausgebildet ist.

8. Stationsanordnung nach einem der Ansprüche 5 bis 8, **dadurch gekennzeichnet, dass** der Stapel statisch gelagert ist und der Transportroboter (101) eine senkrecht zur Transportebene verlaufende Bewegungskomponente umfasst oder der Stapel senkrecht zur Transportebene verfahrbar (132) gelagert ist.

9. Stationsanordnung nach einem der vorhergehenden Ansprüche, **dadurch gekennzeichnet, dass** das mindestens eine Belademodul (130), die mindestens eine Prozessstation (110, 120) und/oder die mindestens eine Vermessstation (110, 120), die mindestens eine Justage/Kühl-Station (140) und/oder die Transportkammer (100) jeweils von den anderen Modulen hermetisch verschließbar ausgebildet sind, sodass der Luftdruck jeweils verschieden regelbar ist.

10. Bearbeitungsverfahren für Halbleiterscheiben (000), bei dem eine in einem Belademodul (130) zur Bevorratung von Halbleiterscheiben (000) bevorratete Halbleiterscheibe (000) mittels eines Transportroboters (101) entnommen, mindestens einer Prozessstation (110, 120) zum Bearbeiten der Halbleiterscheiben (000) zugeführt, in der mindestens einen Prozessstation (110, 120) bearbeitet, anschließend der Prozessstation (110, 120) entnommen und in ein Belademodul (130) rückgeführt wird,
wobei die Halbleiterscheibe (000) nach Entnahme aus dem Belademodul (130) und vor Zuführung in die mindestens eine Prozessstation (110, 120) und/oder nach Entnahme aus der mindestens einen Prozessstation (110, 120) und vor Rückführung in ein Belademodul (130) mittels des Transportroboters (101) durch mindestens eine Justage/Kühl-Station (140) transportiert und dort justiert und/oder gekühlt wird,
**dadurch gekennzeichnet,**
**dass** die Projektion des Transportwegs der mittels des Transportroboters (101) vom mindestens einen Belademodul (130) in eine Justage/Kühl-Station (140) transportierten Halbleiterscheibe (000) auf eine Transportebene je einen geschlossenen Weg beschreibt,
und/oder
die Projektion des Transportwegs der mittels des Transportroboters (101) vom mindestens einen Belademodul (130) über eine Justage/Kühl-Station (140) in die Transportkammer (100) transportierten Halbleiterscheibe (000) auf eine Transportebene und/oder die Projektion des Transportwegs der mittels des Transportroboters (101) von der Transportkammer (100) über eine Justage-/Kühl-Station (140) in die mindestens eine Prozessstation (110, 120) transportierten Halbleiterscheibe (000) auf eine Transportebene je einen direkten Weg beschreibt.

11. Bearbeitungsverfahren nach vorhergehendem Anspruch, **dadurch gekennzeichnet, dass** die Bearbeitung der Halbleiterscheiben (000) in der mindestens einen Prozessstation (110, 120) ein Temperieren, Oxidieren, Sputtern, Beschichten, Ätzen, Oberflächenstrukturieren und/oder Kombinationen hieraus umfasst.

12. Vermessungsverfahren für Halbleiterscheiben (000), bei dem eine in einem Belademodul (130) zur Bevorratung von Halbleiterscheiben (000) bevorratete Halbleiterscheibe (000) mittels eines Transportroboters (101) entnommen, mindestens einer Vermessstation (110, 120) zum Vermessen mindestens einer Messgröße der Halbleiterscheiben (000) zugeführt, in der mindestens einen Vermessstation (110, 120) mindestens eine Messgröße der Halbleiterscheiben (000) vermessen, anschließend die Halbleiterscheibe (000) der Vermessstation (110, 120) entnommen und in ein Belademodul (130) rückgeführt wird,
wobei die Halbleiterscheibe (000) nach Entnahme aus dem Belademodul (130) und vor Zuführung in die mindestens eine Vermessstation (110, 120) und/oder nach Entnahme aus der mindestens einen Vermessstation (110, 120) und vor Rückführung in ein Belademodul (130) mittels des Transportroboters (101) durch mindestens eine Justage-/Kühl-Station (140) transportiert und dort justiert und/oder gekühlt wird,
**dadurch gekennzeichnet,**
**dass** die Projektion des Transportwegs der mittels des Transportroboters (101) vom mindestens einen Belademodul (130) in eine Justage/Kühl-Station (140) transportierten Halbleiterscheibe (000) auf eine Transportebene und/oder die Projektion des Transportwegs der mittels des Transportroboters (101) von einer Justage-/Kühl-Station (140) in die mindestens eine Vermessstation (110, 120) transportierten Halbleiterscheibe (000) auf eine Transportebene je einen geschlossenen Weg beschreibt,
und/oder
die Projektion des Transportwegs der mittels des Transportroboters (101) vom mindestens einen Belademodul (130) über eine Justage/Kühl-Station (140) in die Transportkammer (100) transportierten Halbleiterscheibe (000) auf eine Transportebene und/oder die Projektion des Transportwegs der mittels des Transportroboters (101) von der Transportkammer (100) über eine Justage-/Kühl-Station (140) in die mindestens eine Vermessstation (110, 120) transportierten Halbleiterscheibe (000) auf eine Transportebene je einen direkten Weg beschreibt.

13. Vermessverfahren nach vorhergehendem Anspruch, **dadurch gekennzeichnet, dass** als mindestens eine Messgröße die Oberflächenstrukturierung die Messung von Schichtdicken, die Zusammensetzung der Halbleiterschichten und/oder Kombinationen hieraus vermessen wird.

14. Bearbeitungsverfahren nach einem der Ansprüche 10 bis 11 oder Vermessverfahren nach einem der Ansprüche 12 bis 13, **dadurch gekennzeichnet, dass** die Halbleiterscheiben (000)
a) im Wesentlichen oder vollständig rund, kreisförmig oder oval sind, und/oder
b) eine maximale Dimensionierung von mindestens 100 mm, bevorzugt mindestens 200 mm, insbesondere mindestens 300 mm, besonders bevorzugt mindestens 450 mm aufweisen.

15. Bearbeitungsverfahren nach einem der Ansprüche 10 bis 11 oder 14 oder Vermessverfahren nach einem der Ansprüche 12 bis 14, **dadurch gekennzeichnet, dass** es mit einer Stationsanordnung nach einem der Ansprüche 1 bis 9 durchgeführt wird./
